# EUROPEAN PATENT APPLICATION

(11) **EP 4 804 754 A1**
(43) Date of publication of application: **09.09.2026**
(21) Application number: 25200947.7
(22) Date of filing: 09.09.2025
(51) Int. Cl.: H10D 30/01, H10D 30/47, H10D 62/17, H10D 64/27, H10D 64/00, H10D 62/85

(54) **GAN HEMT WITH WIDE GATE CONTACT AS FIELD PLATE AND HEAT SINK**

(30) Priority: 04.03.2025 US 202519069436
(71) Applicant: GlobalFoundries U.S. Inc., Malta, NY 12020 (US)
(72) Inventor: DeAngelis, Jacob M., Essex Junction 05452 (US); Levy, Mark D., Essex Junction 05452 (US)
(74) Representative: Grünecker Patent- und Rechtsanwälte PartG mbB

(57) **Abstract**

A high electron mobility transistor (HEMT) includes a substrate including a stack of layers including a channel layer, a barrier layer on the channel layer and a two-dimensional electron gas (2DEG) region in the channel layer. An active gate is on the substrate, a drain region is laterally to a first side of the active gate, and a source region is laterally to a second, opposite side of the active gate. A gate contact is electrically coupled to the active gate and extends laterally past at least one edge of the active gate and overlaps the 2DEG region. The gate contact provides heat dissipation and a gate-connected field plate for electric field shaping.

## Description

### STATEMENT REGARDING GOVERNMENT FUNDING

This application was made with government support under contract number HQ0727790700 awarded by the Defense Microelectronics Activity (DMEA). The U.S. government has certain rights in the invention.

### BACKGROUND

The present disclosure relates to transistors, such as III-V high electron mobility transistors (HEMTs). More particularly, the present disclosure relates to embodiments of a HEMT having a wide gate contact to provide a field plate to shape the electric field and a heat sink to reduce self-heating.

III-V semiconductor devices, such as high electron mobility transistors (HEMTs), have emerged as a leading technology for high voltage applications such as power electronics, charging systems, micro-inverters and power adapters, among many other applications. However, as device sizes continue to be reduced to enable better performance, HEMTs can suffer from overheating. HEMTs, in particular, exhibit overheating during on-off switching that can quickly change a bias between 0 and 1000 or more Volts.

### SUMMARY

All aspects, examples and features mentioned below can be combined in any technically possible way.

An aspect of the disclosure relates to a high electron mobility transistor (HEMT) comprising: a substrate including a stack of layers including a channel layer, a barrier layer on the channel layer and a two-dimensional electron gas (2DEG) region in the channel layer; an active gate on the substrate; a drain region laterally to a first side of the active gate; a source region laterally to a second, opposite side of the active gate; and a gate contact electrically coupled to the active gate, wherein the gate contact extends laterally past a first edge of the active gate and overlaps the 2DEG region.

An aspect of the disclosure relates to a high electron mobility transistor (HEMT) comprising: a substrate including a stack of layers including a channel layer, a barrier layer on the channel layer and a two-dimensional electron gas (2DEG) region in the channel layer; an active gate on the substrate; a drain region laterally to a first side of the active gate; a source region laterally to a second, opposite side of the active gate; and a gate contact electrically coupled to the active gate, wherein the gate contact extends laterally past a first edge of the active gate and overlaps the 2DEG region and extends vertically along a sidewall of the active gate, wherein the first edge is closer to the drain region than the source region, and the gate contact is asymmetrical and extends laterally farther toward the drain region than the source region.

An aspect of the disclosure relates to a high electron mobility transistor (HEMT) comprising: a substrate including a stack of layers including a channel layer, a barrier layer on the channel layer and a two-dimensional electron gas (2DEG) region in the channel layer; an active gate on the substrate and including a raised metallic body over a p-type doped gallium nitride (pGaN) layer; a drain region laterally to a first side of the active gate; a source region laterally to a second, opposite side of the active gate; and a gate contact electrically coupled to the active gate, wherein the gate contact extends laterally past a first edge of the active gate and overlaps the 2DEG region, wherein the first edge is closer to the drain region than the source region, and the gate contact is asymmetrical and extends laterally farther toward the drain region than the source region; and an etch stop layer (ESL) vertically at a same level as an upper surface of the active gate, wherein the gate contact extends through the ESL where the gate contact extends laterally past the first edge of the active gate and overlaps the 2DEG region.

Two or more aspects described in this disclosure, including those described in this summary section, may be combined to form implementations not specifically described herein. The details of one or more implementations are set forth in the accompanying drawings and the description below. Other features, objects and advantages will be apparent from the description and drawings, and from the claims.

### BRIEF DESCRIPTION OF THE DRAWINGS

The embodiments of this disclosure will be described in detail, with reference to the following figures, wherein like designations denote like elements, and wherein:
FIG. 1 shows a cross-sectional view of a structure including a high electron mobility transistor (HEMT), according to embodiments of the disclosure;
FIG. 2 shows a cross-sectional view of a structure including a HEMT, according to various embodiments of the disclosure;
FIG. 3 shows a cross-sectional view of a structure including a HEMT, according to various embodiments of the disclosure;
FIG. 4 shows a cross-sectional view of a structure including a HEMT, according to various embodiments of the disclosure;
FIG. 5 shows a cross-sectional view of a structure including a HEMT, according to various embodiments of the disclosure;
FIG. 6 shows a cross-sectional view of a structure including a HEMT, according to various embodiments of the disclosure;
FIG. 7 shows a cross-sectional view of a structure including a HEMT, according to various embodiments of the disclosure; and
FIG. 8 shows a cross-sectional view of a structure including a HEMT, according to various embodiments of the disclosure.

It is noted that the drawings of the disclosure are not necessarily to scale. The drawings are intended to depict only typical aspects of the disclosure and therefore should not be considered as limiting the scope of the disclosure. In the drawings, like numbering represents like elements between the drawings.

### DETAILED DESCRIPTION

In the following description, reference is made to the accompanying drawings that form a part thereof, and in which are shown by way of illustration specific illustrative embodiments in which the present teachings may be practiced. These embodiments are described in sufficient detail to enable those skilled in the art to practice the present teachings, and it is to be understood that other embodiments may be used and that changes may be made without departing from the scope of the present teachings. The following description is, therefore, merely illustrative.

It will be understood that when an element such as a layer, region, or substrate is referred to as being "on" or "over" another element, it may be directly on the other element or intervening elements may also be present. In contrast, when an element is referred to as being "directly on" or "directly over" another element, there may be no intervening elements present. It will also be understood that when an element is referred to as being "connected" or "coupled" to another element, it may be directly connected or coupled to the other element or intervening elements may be present. In contrast, when an element is referred to as being "directly connected" or "directly coupled" to another element, there are no intervening elements present.

Reference in the specification to "one embodiment" or "an embodiment" of the present disclosure, as well as other variations thereof, means that a particular feature, structure, characteristic, and so forth described in connection with the embodiment is included in at least one embodiment of the present disclosure. Thus, the phrases "in one embodiment" or "in an embodiment," as well as any other variations appearing in various places throughout the specification are not necessarily all referring to the same embodiment. It is to be appreciated that the use of any of the following "/," "and/or," and "at least one of," for example, in the cases of "A/B," "A and/or B" and "at least one of A and B," is intended to encompass the selection of the first listed option (a) only, or the selection of the second listed option (B) only, or the selection of both options (A and B). As a further example, in the cases of "A, B, and/or C" and "at least one of A, B, and C," such phrasing is intended to encompass the first listed option (A) only, or the selection of the second listed option (B) only, or the selection of the third listed option (C) only, or the selection of the first and the second listed options (A and B), or the selection of the first and third listed options (A and C) only, or the selection of the second and third listed options (B and C) only, or the selection of all three options (A and B and C). This may be extended, as readily apparent by one of ordinary skill in the art, for as many items listed.

As mentioned above, III-V semiconductor devices, such as high electron mobility transistors (HEMTs), have emerged as a leading technology for high voltage applications, among other applications. However, as device sizes continue to be reduced in size to enable better performance, HEMTs experience higher temperatures and can suffer from overheating. In HEMTs, edges of active gates, especially on the drain side of the transistor, are locations that experience higher self-heating.

In view of the foregoing, disclosed herein are embodiments of a high electron mobility transistor (HEMT) with an enlarged, wide gate contact. The HEMT includes a substrate including a stack of layers including a channel layer, a barrier layer on the channel layer and a two-dimensional electron gas (2DEG) region in the channel layer. An active gate is on the substrate, a drain region is laterally to a first side of the active gate, and a source region is laterally to a second, opposite side of the active gate. The enlarged gate contact is electrically coupled to the active gate and extends laterally past at least one edge of the active gate and overlaps the 2DEG region. The gate contact acts as a heat sink to dissipate heat from the active gate through the interconnect layers to cool likely hot spots within the HEMT, e.g., edges of the active gate. The gate contact thus allows HEMTs that operate at high-power levels with high temperatures to run at a lower temperature through increased cooling provided by the gate contact. As a result, the HEMTs exhibit higher electron mobility, lower internal resistance, better efficiency and radio frequency (RF) performance, and improved longevity. The gate contact also provides a gate-connected field plate for electric field shaping with or without other field plates.

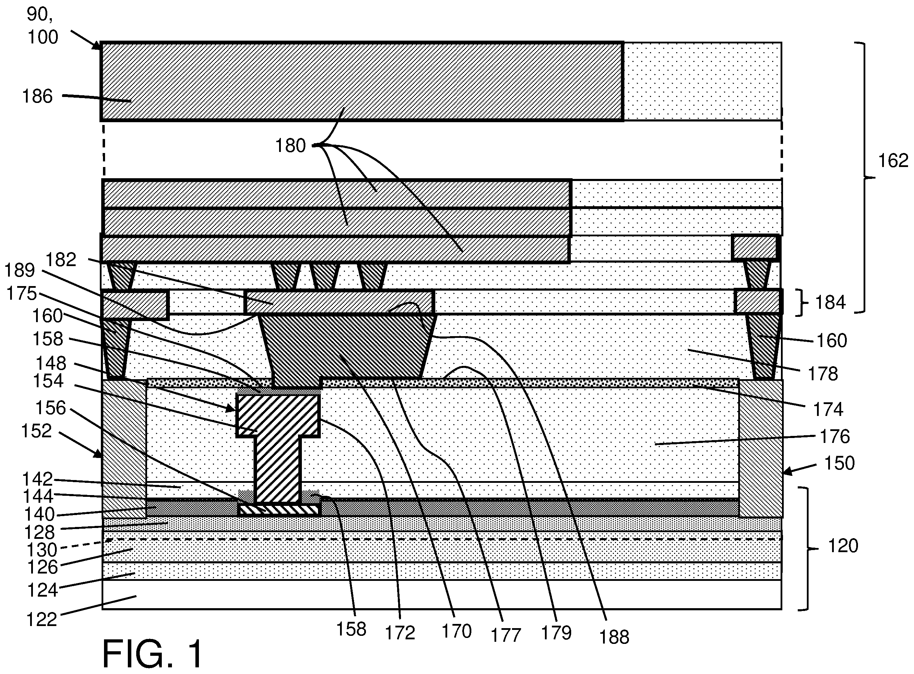

FIGS. 1-8 show cross-sectional views of a structure 90 including a HEMT 100 according to various embodiments of the disclosure. HEMT 100 may include a substrate 120 including a stack of layers, i.e., multiple epitaxially grown semiconductor layers. More particularly, substrate 120 may include a semiconductor base 122 that can be, for example, a silicon or silicon-based substrate (e.g., a silicon carbide (SiC) substrate), a sapphire substrate, a III-V semiconductor substrate (e.g., a gallium nitride (GaN) substrate or some other suitable III-V semiconductor substrate), a silicon substrate (perhaps doped p-type), or any other suitable substrate for a III-V semiconductor device. Epitaxially grown semiconductor layers of substrate 120 can include, for example: an optional buffer layer 124 on the top surface of semiconductor base 122; a channel layer 126 on buffer layer 124; and a barrier layer 128 on channel layer 126. These epitaxial grown semiconductor layers can be, for example, III-V semiconductor layers. Those skilled in the art will recognize that a III-V semiconductor refers to a compound obtained by combining group III elements, such as aluminum (Al), gallium (Ga), or indium (In), with group V elements, such as nitrogen (N), phosphorous (P), arsenic (As) or antimony (Sb)) (e.g., GaN, InP, GaAs, or GaP).

Optional buffer layer 124 can be employed to facilitate growth of channel layer 126 and to provide for lattice constants of semiconductor base 122 below and channel layer 126 above. Buffer layer 124 can be doped or undoped. For example, buffer layer 124 can be carbon-doped. Barrier layer 128 can have a band gap that is wider than the bandgap of channel layer 126 for the device channel. Those skilled in the art will recognize that the barrier and channel materials can be selected so that a heterojunction is formed at the interface between the two layers, thereby resulting in the formation of a two-dimensional electron gas (2DEG) region 130 in channel layer 126 (see dashed box). This 2DEG region 130 in channel layer 126 can provide the conductive pathway for the drifting of charges between a drain region 150 and a source region 152.

In some embodiments, buffer layer 124 could be a carbon-doped gallium nitride (C-GaN) buffer layer or a buffer layer of any other material suitable for use as a buffer layer of a HEMT. Channel layer 126 could be a gallium nitride (GaN) layer or a III-V semiconductor channel layer made of any other III-V semiconductor compound suitable for use as a channel layer in a HEMT. Hence, channel layer 126 may also be referenced as a "GaN channel layer" herein. Barrier layer 128 could be an aluminum gallium nitride (AlGaN) barrier layer or a barrier layer of any other material suitable for use as a barrier layer in a HEMT. Hence, barrier layer 128 may also be referenced as an "AlGaN barrier layer" herein. For purposes of illustration, the figures and the description depict the epitaxially grown layers (e.g., buffer layer 124; channel layer 126; and barrier layer 128) as being single layered structures (i.e., comprising one layer of buffer material, one layer of channel material and one layer of barrier material). However, it should be understood that, alternatively, any one or more of the epitaxially grown layers could be multi-layered structures (e.g., comprising multiple sub-layers of different buffer materials, multiple sub-layers of different III-V semiconductor channel materials and/or multiple sub-layers of different barrier materials).

One or more passivation layers may be over barrier layer 128. In the example shown, two passivation layers 140, 142 are shown with an etch stop layer 144 therebetween. Passivation layers 140, 142 may include one or more layers of any appropriate passivation material such as but not limited to aluminum oxide, silicon nitride and/or silicon oxide. For purposes of illustration, the figures and the description depict passivation layers 140, 142 as being single layered structures. However, it should be understood that, alternatively, one or both passivation layers 140, 142 could be multi-layered structures, e.g., comprising multiple sub-layers of different passivation materials. In certain embodiments, passivation layer 142 may include any interlevel or intralevel dielectric material including inorganic dielectric materials, organic dielectric materials, or combinations thereof. In this case, suitable passivation layer 142 materials may include but are not limited to: silicon oxide; silicon nitride; carbon-doped silicon dioxide materials; fluorinated silicate glass (FSG); organic polymeric thermoset materials; silicon oxycarbide; SiCOH dielectrics; fluorine doped silicon oxide; spin-on glasses; silsesquioxanes, including hydrogen silsesquioxane (HSQ), methyl silsesquioxane (MSQ) and mixtures or copolymers of HSQ and MSQ; benzocyclobutene (BCB)-based polymer dielectrics, and any silicon-containing low-k dielectric.

Etch stop layer 144 may be provided between passivation layers 140, 142 to protect, among other things, the lower passivation layer 140 during etching processes. Etch stop layer 144 may include any now known or later developed etch stop material such as silicon nitride.

HEMT 100 includes an active gate 148 over substrate 120. Active gate 148 extends through passivation (dielectric) layers 140, 142 and etch stop layer 144, to barrier layer 128. HEMT 100 may also include a drain region 150 laterally to a first side (right as shown in the drawings) of active gate 148, and a source region 152 laterally to a second, opposing side (left as shown in the drawings) of active gate 148. Drain region 150 is positioned adjacent to and on an opposing side of active gate 148 from source region 152. Drain region 150 and source region 152 may each include an ohmic metal or metal alloy such as but not limited to titanium aluminum or titanium nitride, to provide ohmic contacts to barrier layer 128. Drain region 150 and source region 152 may be electrically coupled to other parts of structure 90 using source/drain (S/D) contacts 160 and any now known or later developed back-end-of-line (BEOL) interconnect layers 162. BEOL interconnect layers 162 are shown in FIG. 1 only for clarity of illustration in later drawings.

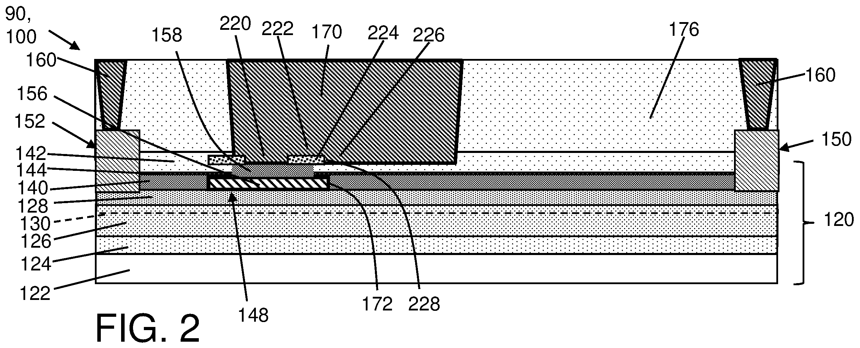

Active gate 148 may take a variety of forms. In certain embodiments, as shown for example in FIG. 1, active gate 148 may include a plurality of layers including, for example, a raised metallic body 154 and a p-type doped gallium nitride (pGaN) layer 156 stacked vertically between barrier layer 128 and raised metallic body 154. Raised metallic body 154 is referenced as "raised" because it extends vertically from pGaN layer 156. Although not required, raised metallic body 154 (hereafter "metallic body 154" for brevity) may be T-shaped to, for example, provide an increased landing area for typically small gate contact. With the inclusion of pGaN layer 156, active gate 148 may also be referenced herein as a "pGaN gate." In other embodiments, as shown for example in FIG. 2, active gate 148 may include pGaN layer 156 without the raised metallic body. Regardless of form, active gate 148 may include a titanium nitride layer 158 over horizontal surfaces thereof.

Those skilled in the art will recognize that with pGaN layer 156 in active gate 148, HEMT 100 functions as an enhancement mode (e-mode) device. Without pGaN layer 156 in active gate 148, HEMT 100 functions as a depletion mode (d-mode) device. While HEMT 100 will be described herein as an enhancement mode HEMT, the teachings of the disclosure are also applicable to a depletion mode HEMT. In certain embodiments, pGaN layer 156 is in direct contact with metallic body 154, i.e., there are no intervening layers. Metallic body 154 includes a single continuous material. Metallic body 154 may include but is not limited to tungsten or copper within a refractory metal liner (not separately shown) of titanium nitride, tantalum or tantalum nitride. As noted, pGaN layer 156 may include, for example, p-type doped gallium nitride. The p-type dopant may include any appropriate p-type dopant for GaN such as but not limited to magnesium, zinc, cadmium and carbon. As noted, active gate 148 is in electric contact with barrier layer 128 so it can control functioning of 2DEG region 130. Active gate 148 may be formed using any now known or later developed semiconductor fabrication techniques as may be appropriate for the materials used, such as material deposition/epitaxial growth, photolithography to pattern certain layers, planarization, etc. Depending on the form of active gate 148, dielectric layer 176, and also perhaps passivation layer 142, may surround active gate 148. Dielectric layer 176 may include one or more layers of any now known or later developed dielectric material such as those listed herein for passivation layer 142 and may be integral with passivation layer 142.

HEMT 100 also includes a gate contact 170 electrically coupled to active gate 148. Unlike conventional gate contacts, gate contact 170 extends laterally past a first edge 172 of active gate 148 and overlaps 2DEG region 130. First edge 172 is closer to drain region 150 than source region 152. Gate contact 170 extends laterally past first edge 172 and overlaps 2DEG region 130 to an extent beyond fabrication tolerances for landing a gate contact on an active gate. Hence, gate contact 170 is purposefully formed to overlap 2DEG region 130 outside of an area under active gate 148. While gate contact 170 is enlarged toward drain region 150, it may not be enlarged in other directions, e.g., into or out of the page. Gate contact 170 is asymmetrical (relative to active gate 148) and extends laterally farther toward drain region 150 than source region 152. In this manner, gate contact 170 provides heat dissipation, i.e., like a heat sink, from active gate 148 and the drift region between active gate 148 and drain region 150. Heat may be further thermally communicated away from the noted area, for example, through interconnect layers 162 to cool likely hot spots within HEMT 100. Gate contact 170 allows HEMT 100 to operate at high-power levels with high temperatures and to run at a lower temperature through increased cooling provided thereby. As a result, HEMT 100 exhibits higher electron mobility, lower internal resistance, better efficiency and radio frequency (RF) performance, and improved longevity.

Gate contact 170 also provides a gate-connected field plate for electric field shaping, i.e., of the drift region between active gate 148 and drain region 150. Field plates are oftentimes used within HEMTs to shape an electric field within the III-V semiconductor substrate 120, which may be irregularly shaped, e.g., with the peak electric field strength in close proximity to sensitive components like active gate 148 of HEMT 100. The strong electric fields may negatively affect the p-type gallium nitride (pGaN) material within active gate 148, for example, as is relevant to this disclosure, by overheating a region next to active gate 148. In FIGS. 1 and 2, gate contact 170 provides the only field plate in HEMT 100. As will be described herein, HEMT 100 may also optionally include other field plate(s).

Gate contact 170 and S/D contacts 160 may include any now known or later developed material typically used for such structure, such as but not limited to tungsten within a refractory metal liner (not separately shown). In certain embodiments, such as those using raised metallic body 154 as shown in FIG. 1, gate contact 170 and S/D contacts 160 may be formed by depositing an etch stop layer (ESL) 174 over dielectric layer 176 in which active gate 148, drain region 150 and source region 152 are formed and then depositing another dielectric layer 178. Dielectric layer 178 may include one or more layers of any now known or later developed dielectric material such as those listed herein for passivation layer 142.

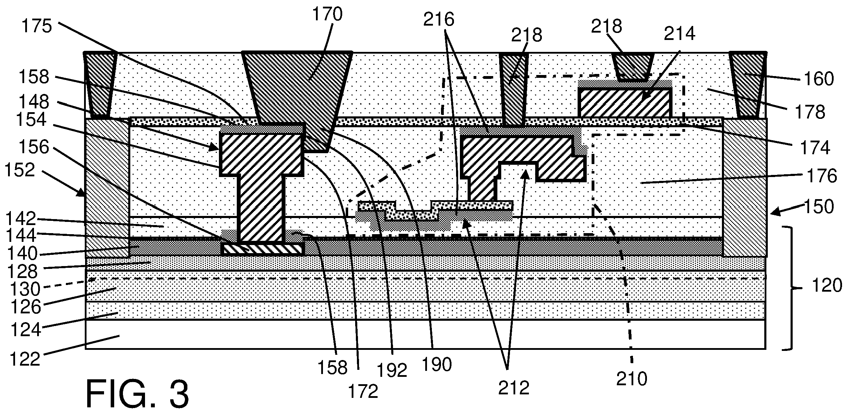

Gate contact 170 and S/D contacts 160 may be formed within predetermined portions of dielectric layer 178 by masking and a controlled amount of vertical etching to form openings to the desired sites and then filling the openings with a refractory metal liner (e.g., titanium nitride) and then a conductor (e.g., copper). In certain embodiments, ESL 174 may be used over and extending laterally away from active gate 148 to prevent over-etching into dielectric layer 178 during formation of, among possibly other structure, gate contact 170. More particularly, ESL 174 may be used in embodiments where active gate 148 includes metallic body 154 over pGaN layer 156. ESL 174 is vertically at a same level as an upper surface 175 of active gate 148 such that a bottom surface of ESL 174 is on upper surface 175 of active gate 148, e.g., of titanium nitride layer 158. ESL 174 may include any now known or later developed etch stop material such as but not limited to silicon nitride. A pre-clean process carried out over gate contact 170 punches through ESL 174 so gate contact 170 can electrically couple to active gate 148. In the FIG. 1 embodiment, gate contact 170 lands on ESL 174 outside of a predetermined area of active gate 148, and gate contact 170 does not extend downwardly past an upper surface 175 of gate contact 170 defined by titanium nitride layer 158. More particularly, gate contact 170 has a lower surface 177 on an upper surface 179 of ESL 174 where gate contact 170 extends laterally past first edge 172 of active gate 148 and overlaps 2DEG region 130. In other embodiments, as shown in the cross-sectional view of FIG. 3, gate contact 170 may extend through ESL 174 and along first edge 172 of active gate 148 where gate contact 170 extends laterally past first edge 172 of active gate 148 and overlaps 2DEG region 130. Here, the pre-clean process used during formation of gate contact 170 punches through ESL 174 so gate contact 170 includes an extension 190 extending through ESL 174 and vertically along first edge 172 of active gate 148, i.e., closest to drain region 150 to dissipate more heat. Here, gate contact 170 directly contacts upper surface 175 of active gate 148 and at least a portion of a first sidewall 192 of active gate 148, e.g., of titanium nitride layer 158 and/or metallic body 154, closest to drain region 150.

Where metallic body 154 is not used in active gate 148, as shown in FIG. 2, ESL 174 (FIG. 1) may not be necessary and may be omitted.

As shown in FIG. 1, gate contact 170 and S/D contacts 160 may be electrically coupled to BEOL interconnect layers 162 thereabove in any now known or later developed fashion. In certain embodiments, gate contact 170 and/or S/D contacts 160 may be simply coupled to BEOL interconnect layers 162 in any now known or later developed manner for operation thereof as part of HEMT 100. In other embodiments, as shown in FIG. 1, gate contact 170 may also optionally be electrically and thermally coupled to a plurality of stacked metal interconnect layers 180 in plurality of BEOL interconnect layers 162. Stacked metal interconnect layers 180 are directly over gate contact 170 to couple gate contact 170 from a wire interconnect 182 in first metal layer 184 to a last metal layer 186 of plurality of BEOL interconnect layers 162. An upper surface 188 of gate contact 170 is coplanar with a bottom surface 189 of first metal layer 184, e.g., wire interconnect 182. Gate contact 170 may be electrically coupled to first metal layer 184. In this manner, a direct thermal path is created between gate contact 170 and last metal layer 186 to dissipate heat. Last metal layer 186 can take any form such as but not limited to a last BEOL interconnect layer 162, a redistribution layer and/or a bond pad. While plurality of metal interconnect layers 180 are shown as wires, it will be recognized that they may also include metal contacts or trench contacts. Plurality of BEOL interconnect layers 162 may include any now known or later developed BEOL interconnect layers. While five BEOL interconnect layers 162 are shown, it is recognized that more or less layers are possible (see vertical dashed lines below upper layers indicating BEOL interconnect layers 162 omitted for clarity).

As understood in the field, BEOL interconnect layers 162 may be formed by depositing an insulator layer, e.g., a dielectric material listed herein for passivation layer 142. One or more of contacts or wires to underlying circuit elements may be formed within predetermined portions of an insulator layer by a controlled amount of vertical etching to form openings to one or more contact or wires sites and then filling the openings with a refractory metal liner and then a conductor. Each contact or wire may include any currently known or later developed conductive material configured for use in an electrical contact or wire, e.g., tungsten, copper, aluminum. Contacts and wires may additionally include refractory metal liners (not shown) positioned alongside the respective insulator layer to prevent electromigration degradation, shorting to other components, etc. Plurality of stacked metal interconnect layers 180 in plurality of BEOL interconnect layers 162 are shown only in FIG. 1 for clarity of illustration but they may be applied to any embodiment described herein.

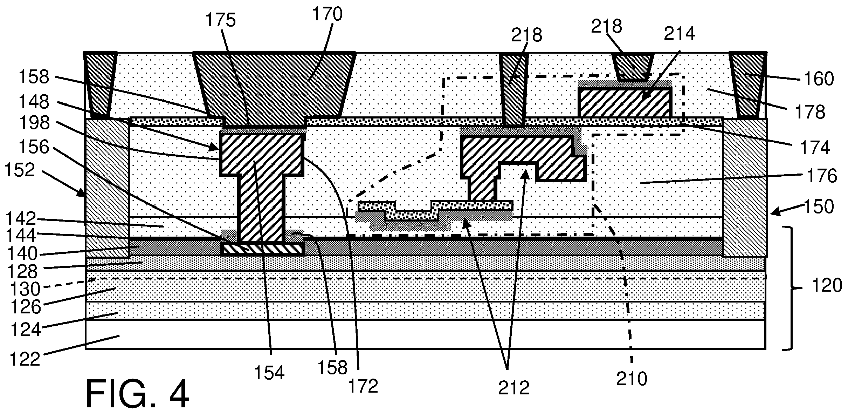

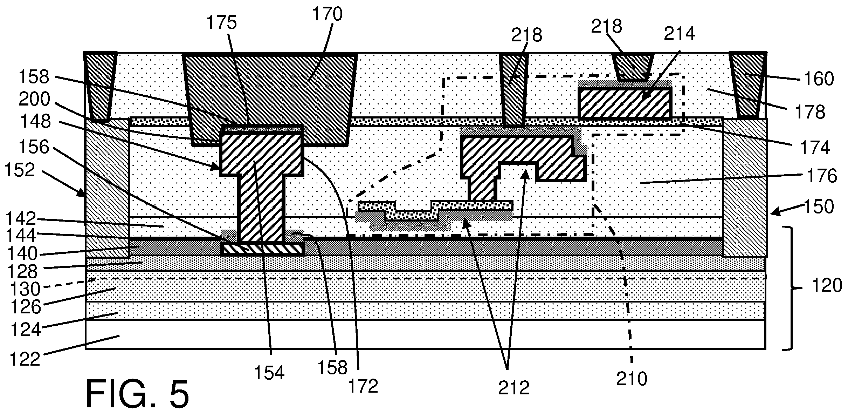

FIGS. 4 and 5 show cross-sectional views of HEMT 100 according to other embodiments. As shown in FIG. 4, in certain embodiments, gate contact 170 may also extend laterally past a second edge 198 of active gate 148 closer to source region 152 than drain region 150 and overlap 2DEG region 130 in that location. As shown in FIG. 5, in certain embodiments, gate contact 170 also directly contacts at least a portion of a second sidewall 200 of active gate 148, i.e., defining second edge 198, closest to source region 152. Hence, gate contact 170 directly contacts upper surface 175 of active gate 148 and at least a portion of second sidewall 200 of active gate 148, e.g., of titanium nitride layer 158 and/or metallic body 154, closest to source region 152. In the FIGS. 4 and 5 embodiments, gate contact 170 is still asymmetrical as in FIG. 1 such that it extends farther towards drain region 150 than source region 152.

FIGS. 3-5 also show an embodiment in which HEMT 100 optionally includes a field plate 210 adjacent active gate 148 and electrically isolated from gate contact 170. Field plate 210 and active gate 148 are electrically isolated by part of dielectric layer 176 therebetween. Although the routing is not shown, field plate 210 may be electrically coupled to source region 152. Field plate 210 (roughly encompassed by dashed box in FIGS. 3-5) is positioned laterally between active gate 148 and one of drain region 150 and source region 152. In the example shown in the drawings, field plate 210 is between active gate 148 and drain region 150, i.e., in a drift region. As noted, field plate 210 is optional and any of the arrangements of gate contact 170 shown with field plate 210 may have the field plate omitted. Similarly, any embodiment shown without field plate 210 may also include the field plate. As noted, field plate 210 is adjacent active gate 148. More particularly, field plate 210 may be positioned laterally to a side of active gate 148. For example, in FIGS. 3-5, field plate 210 is positioned laterally to the right side of active gate 148, but it may alternatively be positioned laterally to the left side of active gate 148. As noted, field plates are oftentimes used within HEMTs to shape an electric field within the III-V semiconductor substrate 120, which may be irregularly shaped, e.g., with the peak electric field strength in close proximity to sensitive components like active gate 148 of HEMT 100. The strong electric fields may negatively affect the p-type gallium nitride (pGaN) material within active gate 148, for example, as is relevant to this disclosure, by overheating a region next to active gate 148. In certain embodiments, field plate 210 may be referred to as a "field plate gate" since it is formed with and similarly situated relative to active gate 148.

Field plate 210 may include a main field plate 212 (perhaps referenced as FP1 and FP2 field plate(s)) closest to active gate 148 and optionally include any variety of field plate extension 214 (FP3) spaced from active gate 148. In certain embodiments, not shown, field plate extension 214 may be omitted, as well as some topography in FP1, or FP1 may be omitted entirely. In other embodiments (not shown), field plate extension 214 may be located in layers lower than active gate 148. For example, field plate extension 214 may be located in passivation layer 140 or 142. In some embodiments, such as the FIG. 2 arrangement, field plate extension 214 may be omitted entirely.

Field plate 210 may include any variety of step therein to provide field shaping to reduce the impact of sharp corners/edges that can result in a strong electric field that can change functions of the devices. Field plate 210 may include the same materials as metallic body 154 of active gate 148. More particularly, field plate 210 may include a metal or metal alloy such as but not limited to aluminum, titanium nitride, tantalum nitride, or tungsten. An ohmic contact layer 216 (FIG. 3 only) such as titanium nitride (TiN) or any other appropriate ohmic contact material, may be under and over parts of field plate 210. Although not shown in detail, it is recognized that active gate 148 and parts of field may include a refractory metal liner to prevent electromigration into surrounding dielectric layer 176. Field plate 210 may be electrically connected to other parts of structure 90 and/or HEMT 100 using any now known or later developed interconnect layers 162 (FIG. 1), i.e., contact(s) 218 in dielectric layer 176 and contacts/wires (not shown) in other interconnect layers 162 (FIG. 1). Contact(s) 218 may be formed similarly to gate contact 170 and/or S/D contacts 160. While a particular arrangement of field plate 210 is shown, a wide variety of other arrangements of field plate 210 are also possible to address different electric fields.

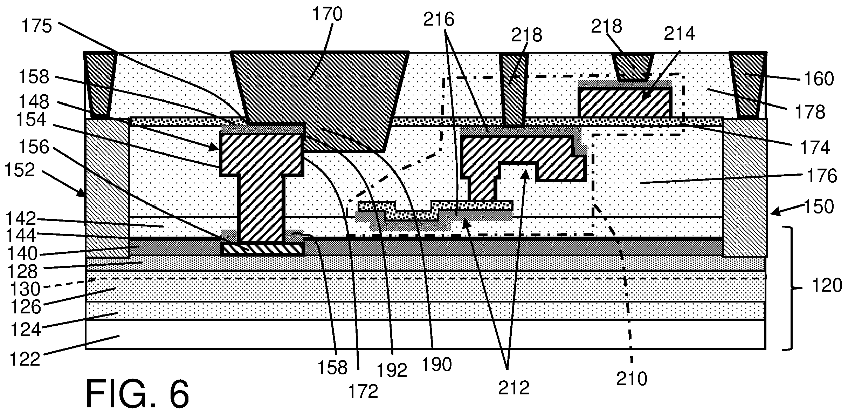

FIG. 6 shows a cross-sectional view of HEMT 100 according to another embodiment. In FIG. 6, gate contact 170 extends farther toward drain region 150 than in FIGS. 1-5 such that it overlaps field plate 210, i.e., part of field plate 210. This arrangement allows some form of field plate to completely cover all parts of the drift region between active gate 148 and drain region 150, which may be beneficial in shaping an electric field of substrate 120. Gate contact 170 may overlap any part of field plate 210, such as but not limited to part of main field plate 212. While FIG. 6 shows gate contact 170 overlapping field plate 210 as it may be arranged in the FIG. 3 embodiment, the teachings of gate contact 170 overlapping field plate 210 may be applied to any other embodiments described herein including field plate 210.

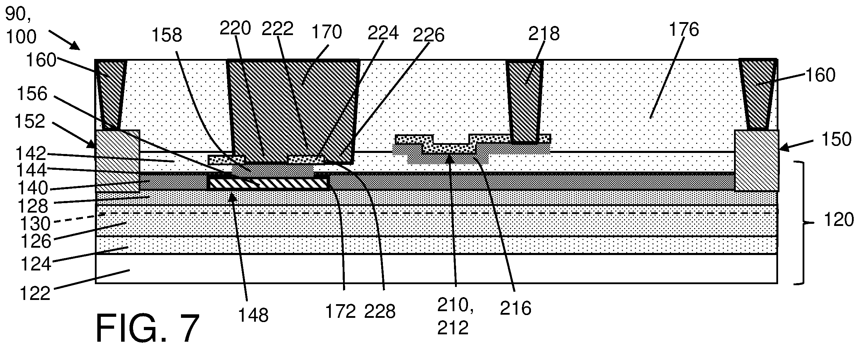

FIG. 7 shows a cross-sectional view of HEMT 100 similar to that in FIG. 2 but including field plate 210. Field plate 210 may include any form of field plate. In the example shown, field plate 210 in FIG. 7 includes just the lowest-most part of main field plate 212 (FP1) as illustrated in other embodiments.

With further regard to gate contact 170 in FIGS. 2 and 7, as noted, active gate 148 may include pGaN layer 156 without metallic body 154 (FIG. 1). In the FIGS. 2 and 7 embodiments, gate contact 170 may include a first portion 220 in direct contact with upper surface 175 of active gate 148, a second portion 222 extending over a portion of an ESL 224 over active gate 148, and a third portion 226 extending over a sidewall 228 of ESL 224 and overlapping 2DEG region 130. ESL 224 is a remnant of the process of forming gate 148. Optionally, ESL 222 instead of terminating above gate 148, as shown, can extend an entire length of the device to aid in creating gate contact 170.

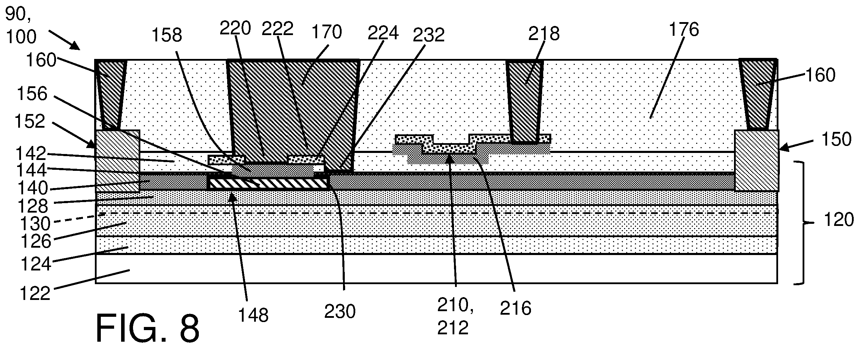

FIG. 8 shows a cross-sectional view of HEMT 100 similar to FIG. 7, except gate contact 170 extends vertically along a sidewall 230 of active gate 148, i.e., pGaN layer 156, to contact ESL 144. More particularly, gate contact 170 includes extension 232 that extends vertically along a sidewall 230 of active gate 148. This arrangement, in which gate contact 170 extends lower or closer to barrier layer 128, allows greater reduction in electric field at the gate edge based on the tunability of the height of extension 232 (overhang) of gate contact 170.

Beyond the fabrication processes previously described herein, HEMT 100 may be formed using any now known or later developed semiconductor fabrication techniques. To summarize, method may include forming a stack of layers, i.e., substrate 120 as described herein, including semiconductor base 122, buffer layer 124, and notably, channel layer 126, barrier layer 128 on channel layer 126, and dielectric layer(s), e.g., passivation layer(s) 140, 142 on barrier layer 128. Channel layer 126 and barrier layer 128 may be formed by epitaxial growth. Dielectric layer(s) may be formed using any now known or later developed deposition technique appropriate for the layers to be formed, e.g., chemical vapor deposition for silicon oxide. The method may also include forming HEMT 100 in the stack such that HEMT 100 includes the features described herein. More particularly, HEMT 100 includes active gate 148 on substrate 120, drain region 150 laterally to a first side (right as shown) of active gate 148, and source region 152 laterally to second, opposing side (left side as shown) of active gate 148. Active gate 148, drain region 150 and source region 152 may be formed by material deposition, e.g., atomic layer deposition (ALD) and photolithographic patterning, of the relevant material layers as described herein. The method may also include forming gate contact 170 as described herein. The method may also optionally include forming field plate 210 adjacent active gate 148, e.g., between active gate 148 and drain region 150. Field plate 210 and gate contact 170 forming may include any now known or later developed interconnect formation, e.g., performing one or more dielectric layer depositions, pattern exposures, etching of openings in the dielectric layer(s), conductor/liner deposition and planarization.

Embodiments of the disclosure provide various technical and commercial advantages, examples of which are discussed herein. The HEMT including the wide gate contact acts as a heat sink to dissipate heat from the active gate, e.g., through the interconnect layers, to cool likely hot spots within the HEMT, e.g., edges of the active gate. The gate contact allows HEMTs that operate at high-power levels with high temperatures to run at a lower temperature through increased cooling provided by the gate contact. As a result, the HEMTs exhibit higher electron mobility, lower internal resistance, better efficiency and radio frequency (RF) performance, and improved longevity. The gate contact also provides a gate-connected field plate for electric field shaping with or without other field plate(s).

It should be understood that in the method and structures described above, a semiconductor material refers to a material whose conducting properties can be altered by doping with an impurity. Example semiconductor materials include, for example, silicon-based semiconductor materials (e.g., silicon, silicon germanium, silicon germanium carbide, silicon carbide, etc.) and III-V compound semiconductors (i.e., compounds obtained by combining group III elements, such as aluminum (Al), gallium (Ga), or indium (In), with group V elements, such as nitrogen (N), phosphorous (P), arsenic (As) or antimony (Sb)) (e.g., GaN, InP, GaAs, or GaP). A pure semiconductor material and, more particularly, a semiconductor material that is not doped with an impurity for the purposes of increasing conductivity (i.e., an undoped semiconductor material) is referred to in the art as an intrinsic semiconductor. A semiconductor material that is doped with an impurity for the purposes of increasing conductivity (i.e., a doped semiconductor material) is referred to in the art as an extrinsic semiconductor and will be more conductive than an intrinsic semiconductor made of the same base material. That is, extrinsic silicon will be more conductive than intrinsic silicon; extrinsic silicon germanium will be more conductive than intrinsic silicon germanium; and so on. Furthermore, it should be understood that different impurities (i.e., different dopants) can be used to achieve different conductivity types (e.g., P-type conductivity and N-type conductivity) and that the dopants may vary depending upon the different semiconductor materials used. For example, a silicon-based semiconductor material (e.g., silicon, silicon germanium, etc.) is typically doped with a Group III dopant, such as boron (B) or indium (In), to achieve P-type conductivity, whereas a silicon-based semiconductor material is typically doped a Group V dopant, such as arsenic (As), phosphorous (P) or antimony (Sb), to achieve N-type conductivity. A gallium nitride (GaN)-based semiconductor material is typically doped with magnesium (Mg) to achieve P-type conductivity and with silicon (Si) or oxygen to achieve N-type conductivity. Those skilled in the art will also recognize that different conductivity levels will depend upon the relative concentration levels of the dopant(s) in a given semiconductor region.

The structure and method as described above are used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier or ceramic carrier, with leads that are affixed to a motherboard or other higher-level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The terminology used herein is for the purpose of describing particular embodiments only and is not intended to be limiting of the disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. "Optional" or "optionally" means that the subsequently described event or circumstance may or may not occur, and that the description includes instances where the event occurs and instances where it does not.

Approximating language, as used herein throughout the specification and claims, may be applied to modify any quantitative representation that could permissibly vary without resulting in a change in the basic function to which it is related. Accordingly, a value modified by a term or terms, such as "about", "approximately" and "substantially", are not to be limited to the precise value specified. In at least some instances, the approximating language may correspond to the precision of an instrument for measuring the value. Here and throughout the specification and claims, range limitations may be combined and/or interchanged, such ranges are identified and include all the sub-ranges contained therein unless context or language indicates otherwise. "Approximately" as applied to a particular value of a range applies to both values, and unless otherwise dependent on the precision of the instrument measuring the value, may indicate +/-10% of the stated value(s).

The corresponding structures, materials, acts, and equivalents of all means or step plus function elements in the claims below are intended to include any structure, material, or act for performing the function in combination with other claimed elements as specifically claimed. The description of the present disclosure has been presented for purposes of illustration and description, but is not intended to be exhaustive or limited to the disclosure in the form disclosed. Many modifications and variations will be apparent to those of ordinary skill in the art without departing from the scope and spirit of the disclosure. The embodiment was chosen and described in order to best explain the principles of the disclosure and the practical application, and to enable others of ordinary skill in the art to understand the disclosure for various embodiments with various modifications as are suited to the particular use contemplated.
In summary, a high electron mobility transistor (HEMT) is provided, the HEMT including a substrate including a stack of layers including a channel layer, a barrier layer on the channel layer and a two-dimensional electron gas (2DEG) region in the channel layer. An active gate is on the substrate, a drain region is laterally to a first side of the active gate, and a source region is laterally to a second, opposite side of the active gate. A gate contact is electrically coupled to the active gate and extends laterally past at least one edge of the active gate and overlaps the 2DEG region. The gate contact provides heat dissipation and a gate-connected field plate for electric field shaping.

The following embodiments are disclosed.

### Embodiment 1:

A high electron mobility transistor (HEMT) comprising:
a substrate including a stack of layers including a channel layer, a barrier layer on the channel layer and a two-dimensional electron gas (2DEG) region in the channel layer;
an active gate on the substrate;
a drain region laterally to a first side of the active gate;
a source region laterally to a second, opposite side of the active gate; and
a gate contact electrically coupled to the active gate, wherein the gate contact extends laterally past a first edge of the active gate and overlaps the 2DEG region.

### Embodiment 2:

The HEMT of embodiment 1, wherein the first edge is closer to the drain region than the source region, and the gate contact is asymmetrical and extends laterally farther toward the drain region than the source region.

### Embodiment 3:

The HEMT of embodiment 1 or 2, wherein the gate contact also extends laterally past a second edge of the active gate closer to the source region than the drain region and overlaps the 2DEG region.
In some special illustrative examples herein, embodiment 3 directly refers back to embodiment 2.

### Embodiment 4:

The HEMT of one of embodiments 1 to 3, further comprising a field plate adjacent the active gate and electrically isolated from the gate contact.

### Embodiment 5:

The HEMT of embodiment 4, wherein the gate contact overlaps the field plate.

### Embodiment 6:

The HEMT of one of embodiments 1 to 5, wherein the active gate includes a raised metallic body over a p-type doped gallium nitride (pGaN) layer, and further comprising an etch stop layer (ESL) vertically at a same level as an upper surface of the active gate, wherein the gate contact has a lower surface on an upper surface of the ESL where the gate contact extends laterally past the first edge of the active gate and overlaps the 2DEG region.

### Embodiment 7:

The HEMT of one of embodiments 1 to 6, wherein the first edge is closer to the drain region than the source region, and the gate contact is asymmetrical and extends laterally farther toward the drain region than the source region.
In some special illustrative examples herein, embodiment 7 directly refers back to embodiment 6.

### Embodiment 8:

The HEMT of one of embodiments 1 to 7, wherein the active gate includes a raised metallic body over a p-type doped gallium nitride (pGaN) layer, and further comprising an etch stop layer (ESL) vertically at a same level as an upper surface of the active gate, wherein the gate contact extends through the ESL where the gate contact extends laterally past the first edge of the active gate and overlaps the 2DEG region.

### Embodiment 9:

The HEMT of one of embodiments 1 to 8, wherein the active gate includes a p-type doped gallium nitride (pGaN) layer, and wherein the gate contact extends vertically along a sidewall of the pGaN layer.

### Embodiment 10:

The HEMT of one of embodiments 1 to 9, wherein the gate contact directly contacts an upper surface of the active gate and at least a portion of a first sidewall of the active gate closest to the drain region.

### Embodiment 11:

The HEMT of one of embodiments 1 to 10, wherein the gate contact directly contacts at least a portion of a second sidewall of the active gate closest to the source region.
In some special illustrative examples herein, embodiment 11 directly refers back to embodiment 10.

### Embodiment 12:

The HEMT of one of embodiments 1 to 11, wherein the gate contact includes a first portion in direct contact with an upper surface of the active gate, a second portion extending over a portion of an etch stop layer (ESL) over the active gate, and a third portion extending over a sidewall of the ESL and overlapping the 2DEG region.

### Embodiment 13:

The HEMT of one of embodiments 1 to 12, wherein the active gate includes a body including a single, continuous material.

### Embodiment 14:

The HEMT of one of embodiments 1 to 13, wherein an upper surface of the gate contact is coplanar with a bottom surface of a first metal layer.

### Embodiment 15:

The HEMT of one of embodiments 1 to 14, wherein the gate contact is electrically coupled to the first metal layer.
In some special illustrative examples herein, embodiment 15 directly refers back to embodiment 14.

### Embodiment 16:

The HEMT of one of embodiments 1 to 15,
wherein the gate contact extends vertically along a sidewall of the active gate, and
wherein the first edge is closer to the drain region than the source region, and
wherein the gate contact is asymmetrical, and
wherein the gate contact extends laterally farther toward the drain region than the source region.

### Embodiment 17:

A high electron mobility transistor (HEMT) comprising:
a substrate including a stack of layers including a channel layer, a barrier layer on the channel layer and a two-dimensional electron gas (2DEG) region in the channel layer;
an active gate on the substrate;
a drain region laterally to a first side of the active gate;
a source region laterally to a second, opposite side of the active gate; and
a gate contact electrically coupled to the active gate, wherein the gate contact extends laterally past a first edge of the active gate and overlaps the 2DEG region and extends vertically along a sidewall of the active gate,
wherein the first edge is closer to the drain region than the source region, and the gate contact is asymmetrical and extends laterally farther toward the drain region than the source region.

### Embodiment 18:

The HEMT of embodiment 16 or 17, wherein the gate contact also extends laterally past a second edge of the active gate closer to the source region than the drain region and overlaps the 2DEG region.

### Embodiment 19:

The HEMT of one of embodiments 16 to 18, further comprising a field plate adjacent the active gate and electrically isolated from the gate contact.

### Embodiment 20:

The HEMT of one of embodiments 1 to 19, further comprising:
an etch stop layer (ESL) vertically at a same level as an upper surface of the active gate, wherein the gate contact extends through the ESL where the gate contact extends laterally past the first edge of the active gate and overlaps the 2DEG region, wherein the active gate on the substrate includes a raised metallic body over a p-type doped gallium nitride (pGaN) layer, and
wherein the first edge is closer to the drain region than the source region, and the gate contact is asymmetrical and extends laterally farther toward the drain region than the source region.

### Embodiment 21:

A high electron mobility transistor (HEMT) comprising:
a substrate including a stack of layers including a channel layer, a barrier layer on the channel layer and a two-dimensional electron gas (2DEG) region in the channel layer;
an active gate on the substrate and including a raised metallic body over a p-type doped gallium nitride (pGaN) layer;
a drain region laterally to a first side of the active gate;
a source region laterally to a second, opposite side of the active gate; and
a gate contact electrically coupled to the active gate, wherein the gate contact extends laterally past a first edge of the active gate and overlaps the 2DEG region, wherein the first edge is closer to the drain region than the source region, and the gate contact is asymmetrical and extends laterally farther toward the drain region than the source region; and
an etch stop layer (ESL) vertically at a same level as an upper surface of the active gate, wherein the gate contact extends through the ESL where the gate contact extends laterally past the first edge of the active gate and overlaps the 2DEG region.

### Embodiment 22:

The HEMT of embodiment 20 or 21, wherein the gate contact directly contacts an upper surface of the active gate and at least a portion of a sidewall of the active gate closest to the drain region.
field plate for electric field shaping.

## Claims

1. A high electron mobility transistor (HEMT) comprising:
a substrate including a stack of layers including a channel layer, a barrier layer on the channel layer and a two-dimensional electron gas (2DEG) region in the channel layer;
an active gate on the substrate;
a drain region laterally to a first side of the active gate;
a source region laterally to a second, opposite side of the active gate; and
a gate contact electrically coupled to the active gate, wherein the gate contact extends laterally past a first edge of the active gate and overlaps the 2DEG region.

2. The HEMT of claim 1, wherein the first edge is closer to the drain region than the source region, and the gate contact is asymmetrical and extends laterally farther toward the drain region than the source region.

3. The HEMT of claim 1 or 2, wherein the gate contact also extends laterally past a second edge of the active gate closer to the source region than the drain region and overlaps the 2DEG region.

4. The HEMT of one of claims 1 to 3, further comprising a field plate adjacent the active gate and electrically isolated from the gate contact, the gate contact preferably overlapping the field plate.

5. The HEMT of one of claims 1 to 4, wherein the active gate includes a raised metallic body over a p-type doped gallium nitride (pGaN) layer, and further comprising an etch stop layer (ESL) vertically at a same level as an upper surface of the active gate, wherein the gate contact has a lower surface on an upper surface of the ESL where the gate contact extends laterally past the first edge of the active gate and overlaps the 2DEG region.

6. The HEMT of one of claims 1 to 5, wherein the first edge is closer to the drain region than the source region, and the gate contact is asymmetrical and extends laterally farther toward the drain region than the source region.

7. The HEMT of one of claims 1 to 6, wherein the active gate includes a raised metallic body over a p-type doped gallium nitride (pGaN) layer, and further comprising an etch stop layer (ESL) vertically at a same level as an upper surface of the active gate, wherein the gate contact extends through the ESL where the gate contact extends laterally past the first edge of the active gate and overlaps the 2DEG region.

8. The HEMT of one of claims 1 to 7, wherein the active gate includes a p-type doped gallium nitride (pGaN) layer, and wherein the gate contact extends vertically along a sidewall of the pGaN layer.

9. The HEMT of one of claims 1 to 8, wherein the gate contact directly contacts an upper surface of the active gate and at least a portion of a first sidewall of the active gate closest to the drain region.

10. The HEMT of one of claims 1 to 9, wherein the gate contact directly contacts at least a portion of a second sidewall of the active gate closest to the source region.

11. The HEMT of one of claims 1 to 10, wherein the gate contact includes a first portion in direct contact with an upper surface of the active gate, a second portion extending over a portion of an etch stop layer (ESL) over the active gate, and a third portion extending over a sidewall of the ESL and overlapping the 2DEG region.

12. The HEMT of one of claims 1 to 11, wherein the active gate includes a body including a single, continuous material.

13. The HEMT of one of claims 1 to 12, wherein an upper surface of the gate contact is coplanar with a bottom surface of a first metal layer, the gate contact being preferably electrically coupled to the first metal layer.

14. The HEMT of one of claims 1 to 13, wherein:
the gate contact extends vertically along a sidewall of the active gate, and
the first edge is closer to the drain region than the source region, and
the gate contact is asymmetrical, and
the gate contact extends laterally farther toward the drain region than the source region.

15. The HEMT of one of claims 1 to 14, further comprising:
an etch stop layer (ESL) vertically at a same level as an upper surface of the active gate, wherein the gate contact extends through the ESL where the gate contact extends laterally past the first edge of the active gate and overlaps the 2DEG region, wherein the active gate on the substrate includes a raised metallic body over a p-type doped gallium nitride (pGaN) layer, and
wherein the first edge is closer to the drain region than the source region, and the gate contact is asymmetrical and extends laterally farther toward the drain region than the source region.
